# EUROPÄISCHE PATENTANMELDUNG

(11) **EP 3 968 032 A1**
(43) Veröffentlichungstag der Anmeldung: **16.03.2022**
(21) Anmeldenummer: 21196114.9
(22) Anmeldetag: 10.09.2021
(51) Int. Cl.: G01R 15/18, G01R 1/04

(54) **VORRICHTUNG ZUR MONTAGE MINDESTENS EINES STROMLEITERS IN EINEM SENSOR UND STROMSENSOR**

(30) Priorität: 11.09.2020 DE 102020123556
(71) Anmelder: MBS AG, 74429 Sulzbach-Laufen (DE)
(72) Erfinder: Gilgen, Wolfgang Heinrich, 74429 Sulzbach-Laufen (DE)
(74) Vertreter: Jakelski & Althoff Patentanwälte PartG mbB

(57) **Zusammenfassung**

Eine Vorrichtung (200) zur Montage mindestens eines Stromleiters (300) in einer Öffnung (110) eines Stromsensors (100),
ist gekennzeichnet durch zwei unter Ausbildung einer Hülse aneinander befestigbaren hülsenförmigen Halbschalen (210, 220), deren Innendurchmesser (d) geringfügig kleiner als der Außendurchmesser (310) des in der Hülse aufgenommenen Stromleiters (300) ist und deren Außendurchmesser (D) zur Ausbildung einer Presspassung der Hülse in dem Stromsensor (100) geringfügig größer als der Innendurchmesser der Öffnung (110) des Stromsensors ausgebildet ist.

## Beschreibung

Die Erfindung betrifft eine Vorrichtung zur Montage mindestens eines Stromleiters in einer Öffnung eines Stromsensors gemäß dem Oberbegriff des Anspruchs 1. Ferner betrifft die Erfindung einen Stromsensor mit einer mittleren Öffnung gemäß dem Oberbegriff des Anspruchs 9.

Stromsensoren sind aus dem Stand der Technik bekannt. Sie kommen bei der leitungsunterbrechungsfreien Messung von Strömen zum Einsatz. Diese Stromsensoren weisen ein Gehäuse auf, welches von zumindest einem Stromleiter, dessen Strom gemessen werden soll, durchquert wird. Der Stromleiter muss dabei in der Öffnung des Gehäuses des Stromsensors montiert werden. Solche Stromsensoren sind zum Beispiel der Homepage der Anmelderin https://mbs-ag.com/produktprogramm/ zu entnehmen.

Um die Leitungen in der Öffnung des Gehäuses derartiger Stromsensoren zu positionieren, werden Montagevorrichtungen verwendet.

Eine solche Montagevorrichtung ist beispielsweise aus der EP 2 527 848 B1 bekannt geworden. Diese Vorrichtung zur Montage mindestens eines Stromleiters in einem Stromabnehmer mit einer Hülse mit einem Durchgang, der sich zwischen einer Eingangsöffnung und einer Ausgangsöffnung entlang einer Symmetrie-Achse der Hülse erstreckt, ist dadurch gekennzeichnet, dass die Hülse aus einem elastischen Material hergestellt ist und zwei flexible Lippen aufweist, die sich radial um ihren äußeren Umfang beidseitig eines Zwischenbereichs erstrecken, wobei die flexiblen Lippen um eine Einbaustellung, in der sie verformt und in Richtung der Hülse gebogen sind, und eine Ruhestellung, in der sie entfaltet sind, einnehmen.

Im montierten Zustand dieser Vorrichtung in einem Stromabnehmer mit einer mittleren Öffnung liegen die Lippen im montierten Zustand der Vorrichtung in dem Stromabnehmer jeweils auf einer der beiden entgegengesetzten Seiten des Stromabnehmers auf.

Die Hülse besteht aus zwei Halbschalen, die über ein Scharnier miteinander verbunden sind. Die beiden Halbschalen können dabei zwischen einer geöffneten Stellung der Hülse, in der ein Stromleiter in die Hülse eingelegt werden kann, und einer geschlossenen Stellung und umgekehrt geschwenkt werden.

Es ist eine Verriegelungsmöglichkeit vorgesehen, in der die beiden Halbschalen unter Ausbildung der Hülse im geschlossenen Zustand verriegelt werden können.

Die Montage eines Stromleiters in einem Stromsensor mittels derartigen Hülsen ist recht aufwendig. Insbesondere sind mehrere Schritte zur Befestigung der Montagevorrichtung in dem Stromsensor erforderlich, um eine präzise und saubere Montage der Vorrichtung in dem Stromsensor zu realisieren, in dem die beiden vorgenannten Lippen an Gehäusewänden des Stromsensors außen aufliegen.

### Offenbarung der Erfindung

Die erfindungsgemäße Vorrichtung zur Montage mindestens eines Stromleiters in einer Öffnung eines Stromsensors mit den Merkmalen des Anspruchs 1 ermöglicht demgegenüber eine sehr schnelle und gleichzeitig präzise Montage eines Stromleiters in einen Stromsensor. Die Vorrichtung ist gekennzeichnet durch zwei unter Ausbildung einer Hülse aneinander befestigbaren hülsenförmigen Halbschalen, deren Innendurchmesser (geringfügig) kleiner als der Außendurchmesser des in der Hülse aufgenommenen Stromleiters ist und deren Außendurchmesser zur Ausbildung einer Presspassung der Hülse in dem Stromsensor (geringfügig) größer als der Innendurchmesser der Öffnung des Stromsensors ausgebildet ist.

Kleiner oder geringfügig kleiner bedeutet dabei, dass der Innendurchmesser der Hülse um 0,1 - 3 %, insbesondere um 0,5 - 2 % und vorzugsweise um 1 % kleiner ist als der Außendurchmesser des in der Hülse aufgenommenen Stromleiters.

Auf diese Weise kann ein Stromleiter in der Hülse, die aus den beiden Halbschalen gebildet wird, befestigt werden, wobei der Stromleiter aufgrund des etwas geringeren Innendurchmessers der beiden hülsenförmigen Halbschalen als der Außendurchmesser des Stromleiters in der Hülse fixiert wird. Die Hülse wird sodann zusammen mit dem in ihr angeordneten und fixierten Stromleiter in einer Öffnung eines Stromsensors befestigt, wobei hier eine Presspassung vorgesehen ist, die dadurch erzielt wird, dass der Außendurchmesser der Hülse geringfügig größer ist als der Innendurchmesser der Öffnung des Stromsensors. Diese Presspassung wird noch dadurch unterstützt, dass der Stromleiter aufgrund der vorgenannten Querschnittverhältnisse einen zusätzlichen Druck radial nach außen ausübt.

Ein geringfügig größerer oder größerer Außendurchmesser der Hülse als der Innendurchmesser der Öffnung des Stromsensors bedeutet in diesem Zusammenhang, dass der Außendurchmesser der Hülse um 0,1 - 3 %, insbesondere um 0,5 - 2 % und vorzugsweise um 1 % größer ist als der Innendurchmesser der Öffnung des Stromsensors.

Gerade die Kombination der Durchmesserverhältnisse, also des Innendurchmessers der Hülse im Verhältnis zu dem Außendurchmesser des in ihr aufgenommenen Stromleiters und des Außendurchmessers der Hülse im Verhältnis zu dem Innendurchmesser in der Öffnung des Stromsensors, wie sie oben beschrieben wurden, bewirken eine sehr schnelle und gleichzeitig sehr feste und sichere Befestigung des Stromleiters in einer Öffnung eines Stromsensors.

Um eine leichte und schnelle und gleichzeitig präzise Befestigung der beiden hülsenförmigen Halbschalen zu ermöglichen, sieht eine besonders vorteilhafte Ausgestaltung vor, dass die beiden hülsenförmigen Halbschalen durch an ihren Schnittflächen angeordnete Befestigungselemente aneinander befestigbar sind. Die Anordnung einer solchen Befestigungsvorrichtung an den Schnittflächen ist besonders gut realisierbar, da die hülsenförmigen Halbschalen eine gewisse Dicke aufweisen, die bei Teilung der Hülse in zwei Hälften zu genügend großen Schnittflächen führen, in der Befestigungselemente angeordnet werden können.

Dabei sieht ein Aspekt der Erfindung vor, dass die Befestigungselemente jeweils durch wenigstens einen an einer Halbschale angeordneten Zentrierzapfen und wenigstens eine, an der anderen Halbschale im montierten Zustand dem Zentrierzapfen gegenüberliegend angeordnete Öffnung gebildet werden.

Ein solcher Zentrierzapfen und eine solche an ihn angepasste Öffnung sind leicht herzustellen und ermöglichen zugleich eine sichere Befestigung der beiden Halbschalen aneinander. Dabei können auch mehr als ein Zentrierzapfen plus zugehöriger Öffnung vorgesehen sein.

Ein besonders vorteilhafter Aspekt der Erfindung sieht vor, dass die beiden hülsenförmigen Halbschalen an ihrem äußeren Umfang jeweils in Längsrichtung verlaufende Befestigungsstege aufweisen. Längsrichtung bedeutet dabei die gleiche Richtung, in der auch der Stromleiter verläuft, also die Axialrichtung der Hülse. Diese Befestigungsstege ermöglichen die eingangs erwähnte vorteilhafte Presspassung der Vorrichtung zur Montage mindestens eines Stromleiters in einer Öffnung eines Stromsensors in der Öffnung des Stromsensors. Dabei ist vorteilhafter Weise vorgesehen, dass die Befestigungsstege jeweils um gleiche Winkel zueinander versetzt an dem äußeren Umfang angeordnet.

Hierdurch wird eine besonders gleichmäßige und damit stabile Befestigung der Vorrichtung für die Montage mindestens eines Stromleiters in einer Öffnung eines Stromsensors ermöglicht. Eine ganz besonders vorteilhafte Ausführungsform sieht vor, dass die hülsenförmigen Halbschalen zur Anpassung ihres Innendurchmessers an ihrer inneren, konzentrischen Öffnung eine Mehrzahl von unterschiedlich weit ins Innere ragenden halbkreisförmigen Vorsprünge aufweist, die zur Anpassung des Innendurchmessers der hülsenförmigen Halbschalen an Sollbruchstellen wegbrechbar oder wegschneidbar sind.

Auf diese Weise kann die Vorrichtung zur Montage mindestens eines Stromleiters in einer Öffnung eines Stromsensors sehr leicht und sehr effektiv an Stromleiter mit unterschiedlichem Außendurchmesser angepasst werden. Auf diese Weise müssen nicht für Stromleiter unterschiedlichen Außendurchmessers unterschiedliche Vorrichtungen zur Montage vorgehalten werden. Es genügt eine einzige Vorrichtung zur Montage, die an den zu montierenden Stromleiter gewissermaßen angepasst werden kann.

Dabei bestehen die hülsenförmigen Halbschalen bevorzugt aus Kunststoff.

Dabei ist gemäß einem sehr vorteilhaften Aspekt der Erfindung vorgesehen, dass der Kunststoff expandiertes Polypropylen (EPP) ist.

Der erfindungsgemäße Stromsensor mit einer mittleren Öffnung, die angeordnet ist, um von mindestens einem Stromleiter durchquert zu werden, in dem eine Vorrichtung zur Montage mindestens eines Stromleiters in einer Öffnung eines Stromsensors der vorstehend beschriebenen Art montiert wird, um den Stromleiter automatisch zu zentrieren, sieht vor, dass die Vorrichtung zur Montage mindestens eines Stromleiters in einer Öffnung eines Stromsensors zusammen mit dem in ihr aufgenommenen Stromleiter in der Öffnung des Stromsensors mittels Presspassung befestigt ist.

Diese Presspassung ermöglicht eine sehr schnelle und gleichzeitig präzise und sichere Montage des Stromleiters in der mittleren Öffnung des Stromsensors.

Weitere Vorteile und Ausgestaltungen der Erfindung ergeben sich aus der Beschreibung und den beiliegenden Zeichnungen.

Es versteht sich, dass die voranstehend genannten und die nachstehenden noch zu erläuternden Merkmale nicht nur in der jeweiligen angegebenen Kombination, sondern auch in anderen Kombinationen oder in Alleinstellung verwendbar sind, ohne den Rahmen der vorliegenden Erfindung zu verlassen.

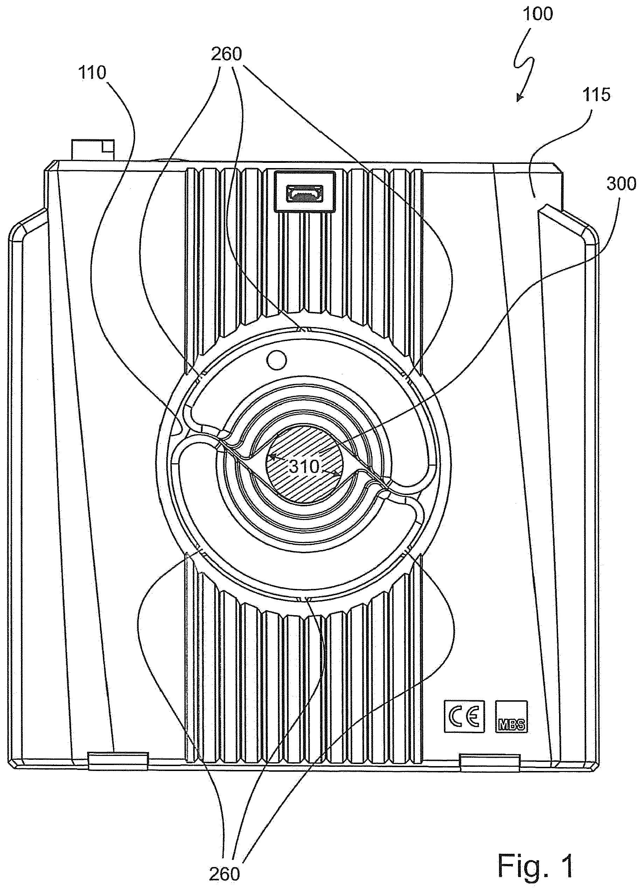

Kurze Beschreibung der Zeichnungen
Fig. 1 zeigt eine schematische Darstellung eines erfindungsgemäßen Stromsensors mit einer in ihm angeordneten Vorrichtung zur Montage mindestens eines Stromleiters und
Fig. 2 eine isometrische Darstellung einer erfindungsgemäßen Vorrichtung zur Montage mindestens eines Stromleiters in einer Öffnung eines Stromsensors.

Ein Stromsensor 100, auch als Stromwandler bezeichnet, weist ein Gehäuse 115 mit einer Öffnung 110 auf, die angeordnet ist, um von zumindest einem (nicht dargestellten) Stromleiter durchquert zu werden. Derartige Stromsensoren dienen der leitungsunterbrechungsfreien Erfassung von Gleich- und Wechselströmen.

Das Gehäuse derartiger Sensoren weist eine hohe klimatische und mechanische Beständigkeit auf, es besteht beispielsweise aus einem PU-Vollverguss.

In der Öffnung 110 ist eine als Ganzes mit 200 bezeichnete Vorrichtung zur Montage mindestens eines Stromleiters 300 angeordnet, die in der Öffnung 110 montiert ist, um den Stromleiter 300 automatisch zu zentrieren.

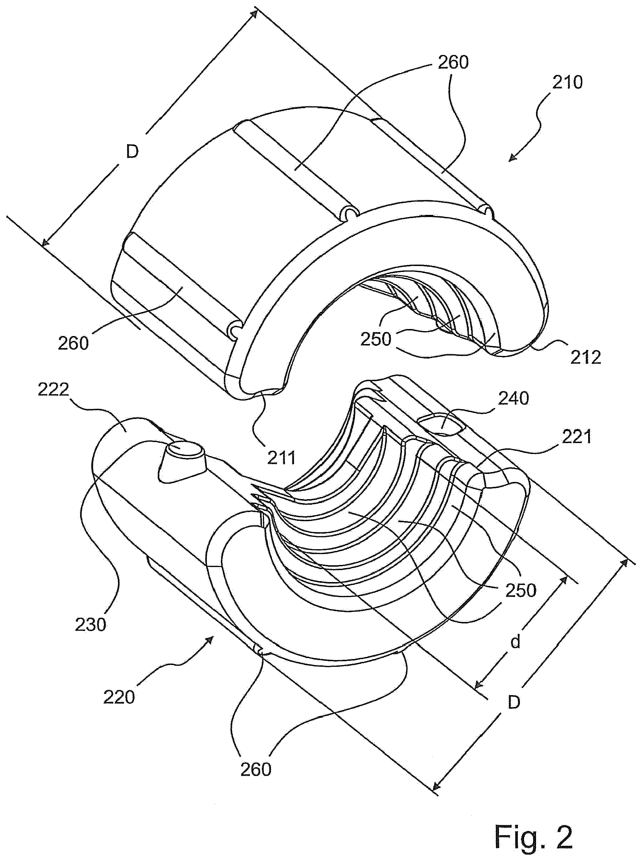

Diese Vorrichtung zur Montage des Stromleiters 300 in der Öffnung 110 ist im nichtmontierten Zustand in Fig. 2 isometrisch dargestellt.

Die Vorrichtung zur Montage des Stromleiters 300 in der Öffnung 110 des Stromsensors 100 weist zwei hülsenförmige Halbschalen 210, 220 auf, die unter Ausbildung einer Hülse aneinander befestigbar sind. Die beiden hülsenförmigen Halbschalen weisen einen Innendurchmesser d auf, der geringfügig kleiner ist als der Außendurchmesser 310 des in der Hülse aufgenommenen Stromleiters 300. Der Außendurchmesser D der hülsenförmigen Halbschalen und damit der Außendurchmesser der im montierten Zustand der beiden hülsenförmigen halbschalen aneinander resultierenden Hülse D ist geringfügig größer als der Innendurchmesser der Öffnung 110 des Stromsensors 100. Auf diese Weise wird die Hülse mittels Presspassung in der Öffnung 110 des Stromsensors 100 montiert. Die beiden hülsenförmigen Halbschalen 210, 220 münden jeweils in Schnittflächen 211, 212 bzw. 221, 222, die eben ausgebildet sein können, jedoch auch gekrümmt verlaufen können. In diesen Schnittflächen 211, 212; 221, 222 sind Befestigungselemente angeordnet, mittels derer die beiden Halbschalen 210, 220 aneinander befestigbar sind. Diese Befestigungselemente können beispielsweise durch Zentrierzapfen 230 und diesen im montierten Zustand der Halbschalen 210, 220 gegenüberliegende, an die Zentrierzapfen 230 angepasste Öffnungen 240 realisiert sein. Dabei sind jeweils in den Halbschalen 210, 220 in einer Schnittfläche 221, 222 eine oder mehrere Öffnungen 240 und in der anderen Schnittfläche 211, 212 eine oder mehrere Zentrierzapfen 230 angeordnet. In der gegenüberliegenden Halbschale 220, 210 sind jeweils die entsprechenden komplementären Befestigungselemente so angeordnet, dass sie den Befestigungselementen in dieser Halbschale 220, 210 gegenüber liegen.

Die beiden hülsenförmigen Halbschalen 210, 220 weisen an ihrem äußeren Umfang jeweils in Axialrichtung, in Richtung des Stromleiters 300 verlaufende Befestigungsstege 260 auf, die jeweils um gleiche Winkel zueinander versetzt an dem äußeren Umfang der Halbschalen 210, 220 angeordnet sind. Der Außendurchmesser der beiden Halbschalen 210, 220 mit den Befestigungsstegen 260 ist dabei geringfügig größer als der Innendurchmesser der Öffnung 110 im Stromsensor 100. Ein geringfügig größerer Außendurchmesser der die Hülse bildenden hülsenförmigen Halbschalen 210, 220 als der Innendurchmesser der Öffnung 110 des Stromsensors 100 bedeutet in diesem Zusammenhang, dass der Außendurchmesser der die Hülse bildenden hülsenförmigen Halbschalen 210, 220 um 0,1 - 3 %, insbesondere um 0,5 - 2 % und vorzugsweise um 1 % größer ist als der Innendurchmesser der Öffnung 110 des Stromsensors 100. Auf diese Weise wird die Vorrichtung zur Montage des Stromleiters 300 in der Öffnung 110 des Stromsensors zusammen mit dem in ihr aufgenommenen Stromleiter 300 mittels Presspassung in der Öffnung 110 des Stromsensors 100 befestigt. Dabei erweist es sich als besonders vorteilhaft, dass der Innendurchmesser d der beiden Halbschalen 210, 220 geringfügig kleiner ist als der Außendurchmesser 310 des in der Vorrichtung zur Montage des Stromleiters 300 aufzunehmenden Stromleiters 300.

Geringfügig kleiner bedeutet dabei, dass der Innendurchmesser der Hülse um 0,1 - 3 %, insbesondere um 0,5 - 2 % und vorzugsweise um 1 % kleiner ist als der Außendurchmesser des in der Hülse aufgenommenen Stromleiters. Auf dieser Weise übt der Stromleiter 300 einen radial nach außen wirkenden Druck auf die Befestigungsstege 260 aus, der die Wirkung der Presspassung unterstützt.

Die innere Öffnung der Vorrichtung zur Montage des Stromleiters 300 weist eine Mehrzahl von unterschiedlich weit ins Innere ragenden halbkreisförmigen Vorsprüngen 250 auf, die zur Anpassung des Innendurchmessers d an Sollbruchstellen der hülsenförmigen Halbschalen 210, 220 wegbrechbar oder wegschneidbar sind. Auf diese Weise kann eine Anpassung des Innendurchmessers d an den Außendurchmesser 310 eines in der Vorrichtung zu montierenden Stromleiters 300 vorgenommen werden. Es kann mit anderen Worten eine solche Vorrichtung zur Montage eines Stromleiters 300 in einer Öffnung 110 eines Stromsensors 100 für Stromleiter unterschiedlichen Außendurchmessers verwendet werden. Eine Anpassung ist leicht möglich.

Die beiden hülsenförmigen Halbschalen 210, 220 bestehen vorzugsweise aus Kunststoff. Dabei hat sich besonders expandiertes Polypropylen (EPP) als besonders vorteilhaft erwiesen.

## Patentansprüche

1. Vorrichtung (200) zur Montage mindestens eines Stromleiters (300) in einer Öffnung (110) eines Stromsensors (100),
**gekennzeichnet durch** zwei unter Ausbildung einer Hülse aneinander befestigbaren hülsenförmigen Halbschalen (210, 220), deren Innendurchmesser (d) geringfügig kleiner als der Außendurchmesser (310) des in der Hülse aufgenommenen Stromleiters (300) ist und deren Außendurchmesser (D) zur Ausbildung einer Presspassung der Hülse in dem Stromsensor (100) geringfügig größer als der Innendurchmesser der Öffnung (110) des Stromsensors (100) ausgebildet ist.

2. Vorrichtung nach Anspruch 1, **dadurch gekennzeichnet, dass** der Innendurchmesser (d) der hülsenförmigen Halbschalen (210, 220) um 0,1 - 3 %, insbesondere um 0,5 - 2 %, vorzugsweise um 1 % kleiner ist als der Außendurchmesser (310) des in der Hülse aufgenommenen Stromleiters (300).

3. Vorrichtung nach Anspruch 1, **dadurch gekennzeichnet, dass** der Außendurchmesser (D) der Hülse in dem Stromsensor (100) um 0,1 - 3 %, insbesondere um 0,5 - 2 %, vorzugsweise um 1 % größer ausgebildet ist als der Innendurchmesser der Öffnung (110) des Stromsensors (100).

4. Vorrichtung (200) nach Anspruch 1, **dadurch gekennzeichnet, dass** die beiden hülsenförmigen Halbschalen (210, 220) durch an ihren Schnittflächen (211, 212; 221,222) angeordnete Befestigungselemente aneinander befestigbar sind.

5. Vorrichtung (200) nach Anspruch 3, **dadurch gekennzeichnet, dass** die Befestigungselemente jeweils durch wenigstens einen an einer Halbschale (210, 220) angeordneten Zentrierzapfen (230) und wenigstens eine an der anderen Halbschale (220, 210), im montierten Zustand dem Zentrierzapfen (230) gegenüberliegend angeordnete Öffnung (240) gebildet werden.

6. Vorrichtung (200) nach Anspruch 1, **dadurch gekennzeichnet, dass** die beiden hülsenförmigen Halbschalen (210, 220) an ihrem äußeren Umfang jeweils in Längsrichtung verlaufende Befestigungsstege (260) aufweisen.

7. Vorrichtung nach Anspruch 6, **dadurch gekennzeichnet, dass** die Befestigungsstege (260) jeweils um gleiche Winkel zueinander versetzt an dem äußeren Umfang angeordnet sind.

8. Vorrichtung nach Anspruch 1, **dadurch gekennzeichnet, dass** die hülsenförmigen Halbschalen (210, 220) zur Anpassung ihres Innendurchmessers (d) an ihrer inneren, konzentrischen Öffnung eine Mehrzahl von unterschiedlich weit ins Innere ragenden halbkreisförmigen Vorsprünge (250) aufweisen, die zur Anpassung des Innendurchmessers (d) der hülsenförmigen Halbschalen (210, 220) an Sollbruchstellen (251) wegbrechbar oder wegschneidbar sind.

9. Vorrichtung nach Anspruch 1, **dadurch gekennzeichnet, dass** die hülsenförmigen Halbschalen (210, 220) aus Kunststoff bestehen.

10. Vorrichtung nach Anspruch 9, **dadurch gekennzeichnet, dass** der Kunststoff expandiertes Polypropylen (EEP) ist.

11. Stromsensor (100) mit einer Öffnung (110), die angeordnet ist, um von zumindest einem Stromleiter (300) durchquert zu werden, wobei der Stromsensor (100) eine Vorrichtung (200) zur Montage mindestens des Stromleiters (300) in der Öffnung (110) des Stromsensors nach einem der Ansprüche 1-8 aufweist, die in der Öffnung (110) montiert ist, um den Stromleiter (300) automatisch zu zentrieren,
**dadurch gekennzeichnet, dass** die Vorrichtung (200) zur Montage des mindestens einen Stromleiters (300) in der Öffnung (110) des Stromsensors (100) zusammen mit dem in ihr aufgenommenen Stromleiter (300) in der Öffnung (110) des Stromsensors (100) mittels Presspassung befestigt ist.
